# EUROPÄISCHE PATENTANMELDUNG

(11) **EP 1 046 859 A1**
(43) Veröffentlichungstag der Anmeldung: **25.10.2000**
(21) Anmeldenummer: 99107720.7
(22) Anmeldetag: 19.04.1999
(51) Int. Cl.: F21K 7/00

(54) **Leuchteinrichtung**

(71) Anmelder: OSHINO LAMPS GmbH, 90425 Nürnberg (DE)
(72) Erfinder: Heinrich, Karl A., 90562 Heroldsberg (DE); Pensl, Karl Dipl.Ing., 96049 Bamberg (DE)
(74) Vertreter: Zech, Stefan Markus Dipl.-Phys.

(57) **Zusammenfassung**

Die Erfindung betrifft eine Leuchteinrichtung, die eine im wesentlichen flächige Leiterplatte (1) mit einer vorbestimmten Anzahl von Leuchtdioden (5) umfaßt, die mit der Leiterplatte (1) elektrisch verbunden sind. Die Leiterplatte (1) ist in einem Leuchtbereich (3) um einen Abstrahlwinkel (δ) von mindestens 90°, vorzugsweise 180° bis 360° gekrümmt. Die Leuchtdioden sind derart auf der gekrümmten Leiterplatte (1) angeordnet, daß im Fernbereich der Leichteinrichtung eine über den Abstrahlwinkel (δ) weitgehend homogene Abstrahlcharakteristik erzeugt wird.

## Beschreibung

Die Erfindung betrifft eine Leuchteinrichtung gemäß dem Oberbegriff des Patentanspruchs 1.

Herkömmliche Leuchteinrichtungen, die eine Leiterplatte und damit elektrisch verbundene Leuchtdioden umfassen, haben den Nachteil, daß sie einen räumlich begrenzten Abstrahlwinkel aufweisen. Insbesondere Signal- oder Zustandsanzeigen, die den Betriebszustand von Geräten und Maschinen anzeigen und auf Störungen hinweisen, benötigen einen räumlich breiten Abstrahlwinkel, damit die Bedienperson den Betriebszustand oder die Störung der Geräte von bestimmten Raumpositionen aus erkennen kann. Bei derartigen Signal- oder Zustandsanzeigen werden daher Glühlampen eingesetzt, da diese eine Lichtabstrahlung über den gesamten Raumwinkel besitzen. Diese Glühlampen sind jedoch mechanischen Belastungen, wie beispielsweise Vibrationen, die von diesen Geräten und Maschinen verursacht werden, ausgesetzt, wodurch die Lebensdauer der Glühlampen stark reduziert wird. Die Glühlampen müssen häufig ersetzt werden, was aufwendig und kostenintensiv ist.

Der Erfindung liegt demgemäß die Aufgabe zugrunde, eine Leuchteinrichtung bereit zu stellen, die sowohl über einen längeren Zeitraum mechanischen Belastungen standhält, als auch über eine räumliche Abstrahlcharakteristik verfügt.

Diese Aufgabe wird mit einer Leuchteinrichtung nach den Merkmalen des Patentanspruchs 1 gelöst. Vorteilhafte Weiterbildungen sind in den Unteransprüchen angegeben.

Ein Kerngedanke der vorliegenden Erfindung besteht darin, daß die Leiterplatte in einem Leuchtbereich um einen Abstrahlwinkel von mindestens 90°, vorzugsweise 180° bis 360° gekrümmt ist, und daß die Leuchtdioden derart auf der gekrümmten Leiterplatte angeordnet sind, daß im Fernbereich der Leuchteinrichtung eine über den Abstrahlwinkel weitgehend homogene Abstrahlcharakteristik erzeugt wird. Diese Leuchteinrichtung hält stärkeren Vibrationen oder Erschütterungen stand und zeichnet sich durch eine hohe Lebensdauer aus. Desweiteren verfügt die erfindungsgemäße Leuchteinrichtung über eine Abstrahlcharakteristik, die mit der Abstrahlcharakteristik der herkömmlichen Glühlampen vergleichbar ist, so daß sie als qualitativ besserer Ersatz der Glühlampen dient. Je nach Krümmung der Leiterplatte wird eine Lichtabstrahlung über den gesamten Raumwinkel, d.h. über einen Winkel von 360°, gewährleistet.

Vorteilhafterweise umfaßt die Leiterplatte neben dem Leuchtbereich äußere Bereiche, insbesondere zur Kontaktierung der Leiterplatte, wobei die äußeren Bereiche jeweils an den Leuchtbereich angrenzen und seitliche Endabschnitte der Leiterplatte bilden. Besonders bevorzugt sind auf einem oder beiden äußeren Bereichen elektrische oder elektronische Bauelemente angeordnet. Durch die räumliche Aufteilung der Leiterplatte in einen Leuchtbereich und zwei äußere Bereiche haben die auf den äußeren Bereichen angeordneten Bauelemente eine gewisse Distanz zu den Leuchtdioden, die sich auf dem Leuchtbereich befinden, so daß die Leuchtdioden nicht permanent der Wärmeausstrahlung der Bauelemente ausgesetzt sind. Insbesondere wird hierdurch eine höhere Lebensdauer der Leuchtdioden gewährleistet.

Vorteilhafterweise ist die Leiterplatte flexibel ausgebildet und erlaubt eine Verformung, so daß die Leiterplatte zu jeder beliebigen Form gebogen werden kann.

Vorzugsweise sind die äußeren Bereiche bei gekrümmter Leiterplatte bezogen auf den Leuchtbereich der Leiterplatte nach innen umgebogen und erstrecken sich in einen vom Leuchtbereich der Leiterplatte gebildeten Innenraum. Durch diese konkrete Maßnahme wird einerseits gewährleistet, daß nur der Leuchtbereich mit den Leuchtdioden von außen sichtbar ist und andererseits wird hierdurch eine größere räumliche Distanz zwischen den elektronischen Bauelementen und den Leuchtdioden geschaffen.

Vorteilhafterweise bilden die äußeren Bereiche Stege, die relativ zum Leuchtbereich der Leiterplatte anschlußseitig vorstehen. Hierdurch wird eine Verlängerung der äußeren Bereiche bewirkt, so daß für die Anordnung der elektronischen Bauelemente mehr Raum zur Verfügung steht.

Gemäß einer weiteren bevorzugten Ausgestaltung ist ein Trägerelement zur Aufnahme und Halterung der gekrümmten Leiterplatte vorgesehen, wobei das Trägerelement aus nichtleitendem Material, insbesondere Keramik oder Kunststoff, hergestellt ist. Damit ist eine sichere und elektrisch isolierte Positionierung der Leiterplatte gewährleistet.

Vorzugsweise ist das Trägerelement als Hohlkörper, insbesondere hohlzylindrisch ausgebildet und weist einen ersten, der Leiterplatte zugeordneten Bereich mit einer Umfangsfläche auf, wobei die Leiterplatte im wesentlichen mit ihrem Leuchtbereich auf der Umfangsfläche des Trägerelements angeordnet ist. Der erste Bereich weist ferner einen längsverlaufenden Spalt auf, derart, daß sich die äußeren Bereiche der Leiterplatte zumindest bereichsweise durch den Spalt in einen Innenraum des Trägerelements erstrecken. Die äußeren Bereiche mit den darauf angeordneten Bauelementen sind somit sicher im Trägerelement aufgenommen und vor äußeren Einflüssen geschützt..

Vorteilhafterweise weist das Trägerelement einen zweiten, einem Anschlußelement zugeordneten Bereich auf, wobei das Anschlußelement vorzugsweise als Sockel ausgebildet ist, und wobei der zweite Bereich definierte Abmessungen aufweist, so daß er in einem Innenraum des Anschlußelements aufnehmbar ist. Hierdurch wird eine kompakte Anordnung der Leuchteinrichtung ermöglicht. Die einbaufertige Leuchteinrichtung entspricht bei dieser Anordnung in etwa der Dimension einer herkömmlichen Glühlampe und kann somit diese in der Anwendung ersetzen.

Besonders bevorzugt erstrecken sich die Stege der äußeren Bereiche der Leiterplatte in den zweiten Bereich des Trägerelements, der ebenfalls hohl ausgebildet ist, wobei an den Stegen Kontaktfahnen zur elektrischen Kontaktierung im Anschlußelement angeordnet sind. Durch diese Maßnahme sind auch die Stege sicher im Trägerelement untergebracht, wobei gleichzeitig die elektrische Kontaktierung der Leiterplatte im Anschlußelement gewährleistet wird.

Vorteilhafterweise ist eine transparente Abdeckung für die gekrümmte Leiterplatte vorgesehen, wobei die Abdeckung vorzugsweise drehfest mit dem Trägerelement verbunden ist. Die Abdeckung dient im Falle des Auswechselns der Leuchteinrichtung als Betätigungsfläche, um das mit der Leiterplatte bestückte Trägerelement zusammen mit dem Anschlußelement in entsprechende Fassungen zu schrauben. Desweiteren dient die Abdeckung zum Schutz der Leiterplatte und kann zugleich als Linse ausgebildet sein, um eine homogenere Abstrahlung zu gewährleisten.

Vorteilhafterweise sind die elektronischen Bauelemente derart ausgelegt, daß sie im Dauerbetrieb oder im Pulsbetrieb arbeiten. Der gepulste Betrieb ist insbesondere dann vorteilhaft, wenn die Helligkeit der Leuchtdioden erhöht werden soll, beispielsweise im Falle einer akuten Störung der Geräte bzw. Maschinen.

Besonders bevorzugt wird die Leuchteinrichtung als Signal- oder Zustandsanzeige verwendet. Hierdurch ergeben sich vielfältige Einsatzgebiete der erfindungsgemäßen Leuchteinrichtung. Beispielsweise eignet sich die Leuchteinrichtung in besonderem Maße als Zustandsanzeige für Maschinen, die unter rauhen Umgebungsbedingungen arbeiten, wie z.B. Stanz- oder Preßmaschinen. Auch eignen sich die Leuchteinrichtungen in hohem Maße als Signalanzeigen an Fertigungslinien oder in Schaltwarten, beispielsweise in Kraftwerken.

Die Erfindung wird nachstehend, auch hinsichtlich weiterer Merkmale und Vorteile anhand der Beschreibung eines Ausführungsbeispiels und unter Bezugnahme auf die beiliegenden Zeichnungen näher erläutert. Hierbei zeigen:
- Fig. 1:: eine Ausführungsform einer erfindungsgemäßen Leuchteinrichtung umfassend eine mit Leuchtdioden bestückte Leiterplatte in räumlicher Anordnung zu einem Trägerelement, einem Anschlußelement und einer Abdeckung in perspektivischer Ansicht;
- Fig. 2:: eine Draufsicht auf die Leiterplatte gemäß der Ausführungsform nach Fig. 1; und
- Fig. 3:: die einbaufertige Leuchteinrichtung nach Fig. 1 in Seitenansicht.

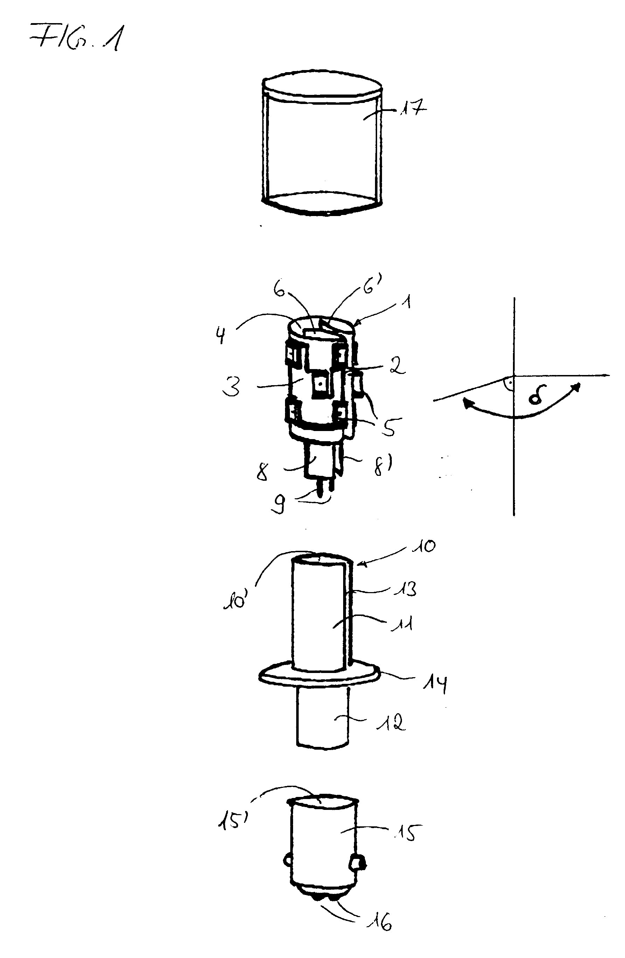

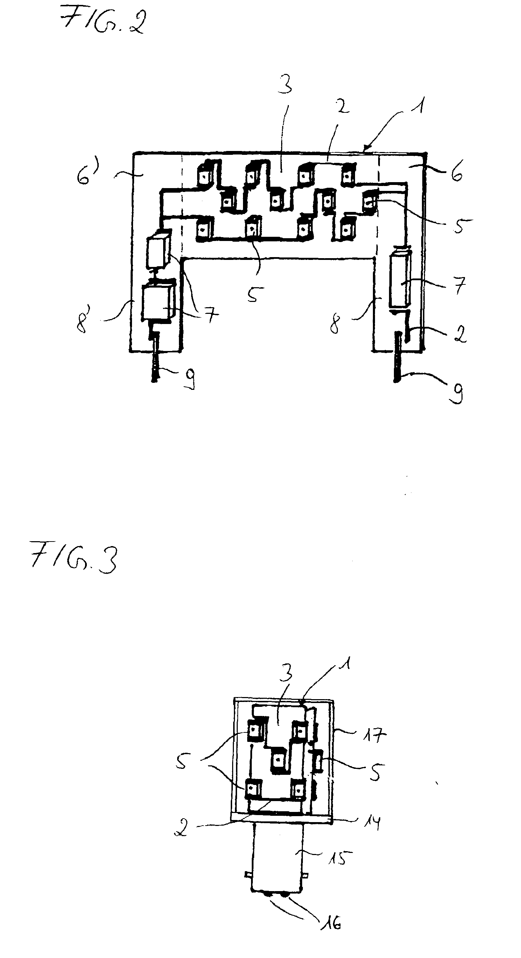

In Fig. 1 ist eine Ausführungsform einer erfindungsgemäßen Leuchteinrichtung gezeigt. Die Leuchteinrichtung umfaßt eine Leiterplatte 1 mit darauf angeordneten Leuchtdioden 5 oder dergleichen Leuchtmittel. Die Leiterplatte 1 ist verformt bzw. gekrümmt und in räumlicher Anordnung zu einem Trägerelement 10, einem Sockel 15 und einer Abdeckung 17 dargestellt. Die Leuchtdioden 5 sind auf nichtleitenden Bereichen der Leiterplatte 1 angeordnet und elektrisch mit Kontakt- oder Leiterbahnen 2 verbunden. Die Leiterplatte 1 ist flächig ausgebildet und weist, wie in Fig. 2 deutlich erkennbar ist, einen inneren Bereich 3 und zwei äußere Bereiche 6, 6' auf, wobei die äußeren Bereiche 6, 6' jeweils an den inneren Bereich 3 angrenzen und seitliche Endabschnitte 6, 6' der Leiterplatte 1 bilden. Die Leuchtdioden 5 sind voneinander beabstandet auf dem inneren Bereich 3 angeordnet und im wesentlichen gleichmäßig über den inneren Bereich 3 der Leiterplatte 1 verteilt. An den seitlichen Endabschnitten 6, 6' der Leiterplatte 1 sind elektrische und elektronische Bauelemente 7, wie beispielsweise Vorwiderstände, Brückengleichrichter und dergleichen angeordnet, die zur elektrischen Beschaltung der Leuchtdioden 5 dienen. Die Endabschnitte 6, 6' umfassen Stege 8, 8', die relativ zum inneren Bereich 3 anschlußseitig vorstehen. An den Stegen 8, 8' sind weitere elektrische und elektronische Bauelemente 7 angeordnet. Zur elektrischen Kontaktierung der Leiterplatte 1 im Sockel 15 sind an den Stegen 8, 8' der seitlichen Endabschnitte 6, 6' Kontaktfahnen 9 angebracht. Die Leiterplatte 1 ist flexibel und wird derart verformt bzw. gekrümmt, daß die seitlichen Endabschnitte 6, 6' der Leiterplatte etwa einander gegenüber liegen oder zumindest bereichsweise benachbart zueinander angeordnet sind. Alternativ kann die Leiterplatte 1 starr ausgebildet sein und entsprechend vorgeformt sein. Die seitlichen Endabschnitte 6, 6' erstrecken sich bei gekrümmter Leiterplatte 1 in den vom inneren Bereich 3 gebildeten Innenraum 4, so daß nur noch der innere Bereich 3 mit den darauf angeordneten Leuchtdioden 5 von außen sichtbar ist. Die gekrümmte Leiterplatte 1 wird auf einem Trägerelement 10 plaziert, das zweckmäßigerweise aus Keramik oder Kunststoff hergestellt ist. Das Trägerelement 10 ist hohlzylindrisch ausgebildet und weist einen ersten, der Leiterplatte 1 zugeordneten Bereich 11 mit einer Umfangsfläche auf, wobei an der Umfangsfläche ein Spalt 13 vorgesehen ist, der sich in Längsrichtung über den ersten Bereich 11 des Trägerelements 10 erstreckt. Die gekrümmte Leiterplatte 1 wird so auf dem Trägerelement 10 bzw. auf dem ersten Bereich 11 positioniert, daß der innere Bereich 3 der Leiterplatte 1 auf der Umfangsfläche des ersten Bereichs 11 des Trägerelements 10 angeordnet wird und die nach innen umgebogenen seitlichen Endabschnitte 6, 6' der Leiterplatte durch den Spalt 13 des Trägerelements geführt werden, so daß sich die Endabschnitte 6, 6' der Leiterplatte 1 einschließlich der Stege 8, 8' in den Innenraum 10' des Trägerelements 10 erstrecken. Die anschlußseitig vorstehenden Stege 8, 8' der seitlichen Endabschnitte 6, 6' der Leiterplatte 1 erstrecken sich in einen zweiten Bereich 12 des Trägerelements 10, wobei der zweite Bereich 12 einem Sockel 15 zugeordnet ist. Der zweite Bereich 12 des Trägerelements 10 weist definierte Abmessungen auf, so daß er in einem Innenraum 15' des Sockels 15 aufgenommen ist. Die Anschlußfahnen 9 werden zur Herstellung des elektrischen Kontaktes jeweils an einer Anschlußstelle 16 am Sockel 15 verlötet.

Zusätzlich kann das Trägerelement 10 einen dem Spalt 13 gegenüberliegenden und sich in den Innenraum 10' erstreckenden längsverlaufenden Vorsprung (nicht gezeigt) aufweisen, so daß die beiden über den Spalt 13 in den Innenraum 10' ragenden seitlichen Endabschnitte 6 und 6' einschließlich der Stege 8 und 8' jeweils voneinander getrennt an den entgegengesetzten Seiten des Vorsprungs angeordnet sind. Hierdurch wird ein elektrischer Kontakt der Bauelemente 7, die auf dem einen seitlichen Endabschnitt 6 angeordnet sind, mit den Bauelementen 7, die sich auf dem anderen seitlichen Endabschnitt 6' befinden, vermieden.

Alternativ können die Bauelemente 7 an den Endabschnitten 6 und 6' mit geeignetem Isoliermittel behandelt oder überzogen werden, so daß trotz einer räumlichen Nähe der einander gegenüberliegenden Bauelemente 7 ein elektrische Kontakt verhindert wird.

Zwischen dem ersten Bereich 11 und dem zweiten Bereich 12 des Trägerelements 10 ist ein Stützteil 14 angeordnet, das entweder als separates Bauteil vorgesehen sein kann oder einstückig mit dem Trägerelement 10 ausgebildet sein kann. Das Stützteil dient einerseits zur Abstützung des Trägerelements 10 am Sockel 15 und andererseits zur Aufnahme bzw. Befestigung einer transparenten Abdeckung 17. Die Abdeckung 17 ist zweckmäßigerweise zylindrisch ausgebildet und dient zum Schutz der gekrümmten Leiterplatte 1. Die Abdeckung 17 wird am Stützteil 14, das entsprechend der Form der Abdeckung 17 zweckmäßigerweise scheiben- oder ringförmig ausgestaltet ist, drehfest angeordnet, beispielsweise durch Verkleben mit dem Stützteil 14. Alternativ kann die Abdeckung 17 am Stützteil 14 mittels einer drehfesten Verrastung befestigt sein. Zu diesem Zweck sind an der Abdeckung 17 und/oder am Stützteil 14 Rastmittel (nicht gezeigt) vorgesehen, die in korrespondierende Rastmittel am Stützteil 14 und/oder an der Abdeckung 17 eingreifen.

Die Abdeckung 17 kann zusätzlich als Linse ausgebildet sein, um eine homogenere Abstrahlung zu gewährleisten.

Der zweite Bereich 12 des Trägerelements 10 wird mit dem Sockel 15, beispielsweise durch Verkleben, fest verbunden. Für die Leuchteinrichtung wird bevorzugt ein Standardsockel vom Typ Ba 15 d verwendet, so daß die Leuchteinrichtung vielseitig einsetzbar ist, und gegen die herkömmlichen Glühlampen ausgewechselt werden kann. Falls erforderlich, können auch andere Sockeltypen eingesetzt werden, wobei der zweite Bereich 12 des Trägerelements den Abmessungen des jeweiligen Sockeltyps entsprechend angepaßt ist.

In Fig. 3 ist die Leuchteinrichtung im einbaufertigen Zustand gezeigt. Deutlich zu sehen ist die gleichmäßige Anordnung der Leuchtdioden 5 auf der Leiterplatte 1. Um eine gleichmäßige räumliche Lichtabstrahlung zu erzielen, sind etwa 8 bis 12 Leuchtdioden gleichmäßig über den inneren Bereich 3 der Leiterplatte 1 verteilt und strahlen das Licht über den gesamten Umfang des inneren Bereichs 3 der Leiterplatte 1 ab. Der Abstrahlwinkel δ beträgt etwa 360°. Je nach erwünschtem Helligkeitsgrad können mehr (oder weniger) Leuchtdioden eingesetzt werden, wobei bevorzugt Leuchtdioden vom Typ SMD (Surface Mount Device) verwendet werden. Durch die Verwendung von SMD-Leuchtdioden oder SMD-Bauelementen ist eine automatische Bestückung der Leiterplatte möglich. Je nach gefordertem Einsatzfall können alle derzeit verfügbaren LED-Lichtfarben eingesetzt werden. Die Leuchtdioden 5 können entweder rein parallel oder teilweise parallel und teilweise seriell geschaltet sein.

Die elektrischen und elektronischen Bauelemente 7 sind vollständig im Innenraum 10' des Trägerelements 10 aufgenommen und von außen nicht sichtbar. Die elektrischen und elektronischen Bauelemente 7 stellen für die Leuchtdioden 5 den Betriebsstrom zur Verfügung und sind so ausgelegt, daß sie im Dauerbetrieb oder im Pulsbetrieb arbeiten können. Ein gepulster Betrieb der Bauelemente 7 bietet sich insbesondere dann an, wenn die Helligkeit der Leuchtdioden 5 erhöht werden soll.

Die oben beschriebene Leuchteinrichtung ist in vielen Gebieten einsetzbar, da sie zuverlässig arbeitet und auch stärkeren Vibrationen standhält. Desweiteren verfügt die Leuchteinrichtung über eine homogene Lichtabstrahlung, die über den gesamten Raumwinkel erfolgt. Besonders bevorzugt wird die Leuchteinrichtung als Signal- oder Zustandsanzeige verwendet. Durch die kompakte Anordnung der Leuchteinrichtung im einbaufertigen Zustand und durch die Anpassung des mit der Leiterplatte bestückten Trägerelements an genormte Sockel kann die Leuchteinrichtung die Glühlampe in am Markt verfügbaren Signal- und Warnleuchten ersetzen.

### Bezugszeichenliste

- 1:: Leiterplatte
- 2:: Kontaktbahn
- 3:: innerer Bereich (Leiterplatte)
- 4:: Innenraum
- 5:: Leuchtdioden
- 6, 6':: seitliche Endabschnitte (Leiterplatte)
- 7:: elektronische Bauelemente
- 8,8':: Stege
- 9:: Kontaktfahne
- 10:: Trägerelement
- 10':: Innenraum (Trägerelement)
- 11:: erster Bereich (Trägerelement)
- 12:: zweiter Bereich (Trägerelement)
- 13:: Spalt
- 14:: Stützteil
- 15:: Sockel
- 15':: Innenraum (Sockel)
- 16:: Kontaktstelle
- 17:: Abdeckung

## Patentansprüche

1. Leuchteinrichtung, umfassend eine im wesentlichen flächige Leiterplatte (1) mit einer vorbestimmten Anzahl von Leuchtdioden (5) die mit der Leiterplatte (1) elektrisch verbunden sind,
**dadurch gekennzeichnet,**
daß die Leiterplatte (1) in einem Leuchtbereich (3) um einen Abstrahlwinkel (δ) von mindestens 90°, vorzugsweise 180° bis 360° gekrümmt ist, und daß die Leuchtdioden (5) derart auf der gekrümmten Leiterplatte (1) angeordnet sind, daß im Fembereich der Leuchteinrichtung eine über den Abstrahlwinkel (δ) weitgehend homogene Abstrahlcharakteristik erzeugt wird.

2. Leuchteinrichtung nach Anspruch 1,
**dadurch gekennzeichnet,**
daß die Leiterplatte (1) neben dem Leuchtbereich (3) äußere Bereiche (6, 6') insbesondere zur Kontaktierung der Leiterplatte (1) umfaßt, wobei die äußeren Bereiche (6, 6') jeweils an den Leuchtbereich (3) angrenzen und seitliche Endabschnitte (6, 6') der Leiterplatte (1) bilden.

3. Leuchteinrichtung nach Anspruch 1 oder 2,
**dadurch gekennzeichnet,**
daß auf einem oder beiden äußeren Bereichen (6, 6') elektrische oder elektronische Bauelemente (7) angeordnet sind.

4. Leuchteinrichtung nach einem der Ansprüche 1 bis 3,
**dadurch gekennzeichnet,**
daß die Leiterplatte (1) derart gekrümmt, ist, daß die äußeren Bereiche (6, 6') der Leiterplatte (1) zumindest bereichsweise benachbart zueinander angeordnet sind.

5. Leuchteinrichtung nach einem der Ansprüche 1 bis 4,
**dadurch gekennzeichnet,**
daß die Leiterplatte (1) flexibel ausgebildet ist und eine Verformung erlaubt.

6. Leuchteinrichtung nach einem der Ansprüche 1 bis 5,
**dadurch gekennzeichnet,**
daß die äußeren Bereiche (6, 6') bei gekrümmter Leiterplatte (1) bezogen auf den Leuchtbereich (3) der Leiterplatte (1) nach innen umgebogen sind und sich in einen vom Leuchtbereich (3) der Leiterplatte (1) gebildeten Innenraum (4) erstrecken.

7. Leuchteinrichtung nach einem der Ansprüche 1 bis 6,
**dadurch gekennzeichnet,**
daß die äußeren Bereiche (6, 6') der Leiterplatte (1) Stege (8, 8') bilden, die relativ zum Leuchtbereich (3) der Leiterplatte (1) anschlußseitig vorstehen.

8. Leuchteinrichtung nach einem der Ansprüche 1 bis 7,
**dadurch gekennzeichnet,**
daß ein Trägerelement (10) zur Aufnahme und Halterung der gekrümmten Leiterplatte (1) vorgesehen ist, wobei das Trägerelement (10) aus nichtleitendem Material, insbesondere Keramik oder Kunststoff, hergestellt ist.

9. Leuchteinrichtung nach Anspruch 8,
**dadurch gekennzeichnet,**
daß das Trägerelement (10) als Hohlkörper, insbesondere hohlzylindrisch, ausgebildet ist und einen ersten, der Leiterplatte (1) zugeordneten Bereich (11) mit einer Umfangsfläche aufweist, wobei die Leiterplatte (1) im wesentlichen mit ihrem Leuchtbereich (3) auf der Umfangsfläche des Trägerelements (10) angeordnet ist, und daß der erste Bereich (11) einen längsverlaufenden Spalt (13) aufweist, derart, daß sich die äußeren Bereiche (6, 6') der Leiterplatte (1) zumindest bereichsweise durch den Spalt (13) in einen Innenraum (10') des Trägerelements (10) erstrecken.

10. Leuchteinrichtung nach Anspruch 8 oder 9,
**dadurch gekennzeichnet,**
daß das Trägerelement (10) einen zweiten, einem Anschlußelement (15) zugeordneten Bereich (12) aufweist, wobei das Anschlußelement (15) vorzugsweise als Sockel ausgebildet ist, und wobei der zweite Bereich (12) definierte Abmessungen aufweist, so daß er in einem Innenraum (15') des Anschlußelements (15) aufnehmbar ist.

11. Leuchteinrichtung nach einem der Ansprüche 1 bis 10,
**dadurch gekennzeichnet,**
daß sich die Stege (8, 8') der äußeren Bereiche (6, 6') in den zweiten Bereich (12) des Trägerelements (10) erstrecken, wobei an den Stegen (8, 8') Kontaktfahnen (9) zur elektrischen Kontaktierung im Anschlußelement (15) angeordnet sind.

12. Leuchteinrichtung nach einem der Ansprüche 1 bis 11,
**dadurch gekennzeichnet,**
daß eine transparente Abdeckung (17) für die gekrümmte Leiterplatte (1) vorgesehen ist, wobei die Abdeckung (17) vorzugsweise drehfest mit dem Trägerelement (10) verbunden ist.

13. Leuchteinrichtung nach Anspruch 12,
**dadurch gekennzeichnet,**
daß zur Befestigung der Abdeckung (17) ein Stützteil (14) vorgesehen ist, wobei das Stützteil (14) zwischen dem ersten Bereich (11) und dem zweiten Bereich (12) des Trägerelements (10) angeordnet ist und gleichzeitig zur Abstützung des Trägerelements (10) am Anschlußelement (15) dient.

14. Leuchteinrichtung nach Anspruch 13,
**dadurch gekennzeichnet,**
daß das Stützteil (14) der Form der Abdeckung (17) angepaßt ist, wobei an der Abdeckung (17) und/oder am Stützteil (14) Rastmittel vorgesehen sind, die in korrespondierende Rastmittel am Stützteil (14) und/oder an der Abdeckung (17) eingreifen.

15. Leuchteinrichtung nach einem der Ansprüche 1 bis 14,
**dadurch gekennzeichnet,**
daß die Leuchtdioden (5) parallel oder teilweise parallel und teilweise seriell geschaltet sind.

16. Leuchteinrichtung nach einem der Ansprüche 1 bis 15,
**dadurch gekennzeichnet**,
daß die elektrischen und elektronischen Bauelemente (7) so ausgelegt sind, daß sie im Dauerbetrieb oder im Pulsbetrieb arbeiten.

17. Leuchteinrichtung nach einem der Ansprüche 1 bis 16, wobei die Leuchteinrichtung als Signal-oder Zustandsanzeige verwendet wird.
